# EUROPEAN PATENT SPECIFICATION

(11) **EP 0 525 827 B1**
(45) Date of publication and mention of the grant of the patent: **07.06.1995**
(21) Application number: 92116683.1
(22) Date of filing: 29.03.1988
(51) Int. Cl.: H01L 39/24

(54) **Method of producing superconducting wire**
Verfahren zur Herstellung eines supraleitenden Drahts
Procédé de fabrication d'un fil supraconducteur

(30) Priority: 31.03.1987 JP 80028/87; 09.10.1987 JP 254969/87
(43) Date of publication of application: 03.02.1993
(62) Divisional of application: 88105114.8
(73) Proprietor: SUMITOMO ELECTRIC INDUSTRIES LIMITED, Osaka-shi, Osaka 541 (JP)
(72) Inventor: Yamauchi, Kazuhisa, c/o Osaka Works of Sumitomo, Konohana-ku, Osaka (JP); Ohmatsu, Kazuya, c/o Osaka Works of Sumitomo, Konohana-ku, Osaka (JP); Ishida, Tetsuya, c/o Itami Works of Sumitomo, Itami-shi, Hyogo-ken (JP); Gotoh, Tomoji, c/o Itami Works of Sumitomo, Itami-shi, Hyogo-ken (JP); Yazu, Syuji, c/o Itami Works of Sumitomo, Itami-shi, Hyogo-ken (JP); Jodai, Tetsuji, c/o Itami Works of Sumitomo, Itami-shi, Hyogo-ken (JP)
(74) Representative: KUHNEN, WACKER & PARTNER

(56) References cited:
- EP-A- 0 069 896
- FR-A- 2 615 651
- US-A- 3 708 606
- PHYSICAL REVIEW LETTERS vol. 58, no. 9, 2 March 1987, NEW YORK US, pp. 908-910 ; M.K. WU ET AL. 'SUPERCONDUCTIVITY AT 93 K IN A NEW MIXED-PHASE Y-BA-CU-O COMPOUND SYSTEM AT AMBIENT PRESSURE'
- ADVANCED CERAMIC MATERIALS- CERAMIC SUPERCONDUCTORS vol. 2, no. 3B, July 1987, WESTERVILLE OH, US, pp. 388-400 ; R.W. MCCALLUM ET AL. 'PROBLEMS IN THE PRODUCTION OF YBA2CU3OX SUPERCONDUCTING WIRE'

## Description

### DETAILED DESCRIPTION OF THE INVENTION

### [Field of the Invention]

The present invention relates to a method of producing a superconducting wire consisting of a usual conductor and a superconductor capable of effectively utilizing a superconducting material having a high superconducting critical temperature.

### [Prior Art and Problems to be Solved]

A substance exhibits a complete diamagnetism under the superconducting phenomenon and a potential difference disappears even though a definite stationary current passes through an inside of the substance. So, various kinds of application of the superconductor as a transmission medium without showing any loss of electric power have been proposed.

That is to say, the fields of the superconductor include remarkably many fields such as an electric power field, such as MHD generation of electricity, transmission of electric power and storage of electric power, power field, such as magnetic levitation train and electro-magnetic propelling ship, and instrumental field, such as NMR, π-meson medical treatment and high-energy physics experimental apparatus as a supersensitive sensor for a magnetic field, microwave, radio-active beam and the like.

In addition, the superconductor has been expected as an art capable of not only reducing a consumption of electric power but also realizing an element, which is remarkably speedy in action, also in the field of electronics represented by a Josephson's devices.

The superconductivity has been a phenomenon which is observed only at superlow temperatures. That is to say, a remarkably low temperature of 23.2 K has been said to be the limit of the superconducting critical temperature even for Nb₃Ge, which has been said to be the conventional superconducting material having the highest superconducting critical temperature Tc, for a long time.

Accordingly, the superconducting material has been cooled to Tc or less using liquid helium having a boiling point of 4.2 K to realize the superconducting phenomenon. However, the use of liquid helium has led to a remarkably increased technical burden and burden in cost due to a cooling facility including a liquefying device, and thus the realization of superconducting technique has been hindered.

It has, however, been recently reported that a sintered body comprising an oxide of elements of the group IIa or IIIa in the periodic table can be a superconductor having a remarkably high Tc, and thus the realization of the superconducting technique using a non-low temperature superconductor is going to be rapidly promoted. Composite oxides having a so-called pseudo-perovuskite type crystalline structure such as [La, Ba]₂CuO₄ or [La, Sr]₂CuO₄, which seem to have an orthorhombic structure and the like similar to the crystalline structure of perovuskite type oxides, have been already reported. Tc of 30 to 50 K remarkably high in comparison with that of the conventional superconducting materials has been observed for these substances. In addition, also Tc of 70 K or more has been reported for superconducting materials formed of oxides of Ba, Y and Cu.

However, since these superconducting materials are obtained in the form of sintered body at present, that is, they are produced by sintering molded products having an appointed length in a lump, a method of continuously producing a long object, such as a wire, has not been developed. In addition, the superconducting material obtained in the form of sintered body is remarkably fragile, so that the superconducting material is difficult to mold in many cases.

In addition, a method, in which the superconducting wire is preliminarily produced and then coated with a usual conductor, has been used as a method of producing the composite wire consisting of the usual conductor and the superconductor.

However, according to such method, the process of producing the superconducting wire and the process of coating the superconducting wire with the usual conductor are required, so that such method is not efficient.

Thus, it is an object of the present invention to solve the above described points of problem of the conventional arts, whereby providing a novel method of continuously producing a superconducting material having a high Tc in the form of a wire highly stable in superconducting characteristic and superior in maintenance of shape.

It is another object of the present invention to provide a method of producing a composite wire comprising a superconductor in one step.

### [Measures for Solving the Problems]

In order to achieve the object, according to the present invention, a band conductor consisting of a metal or of an alloy, being continuously supplied, is bent in a flume-like shape and then the resulting bent concave portion is supplied with an oxide superconducting material followed by bending said conductor, so that a slight gap is left between both edges of the bent band conductor, to envelop said material in the conductor. Subsequently, said material is sintered and then subjected to rolling to a clad wire of a desired diameter.

Raw material powders preferably include mixture powders formed of oxides, nitrides, fluorides, carbonates, nitrates, oxalates or sulfates of one kind or element α selected from elements of the group IIa in the periodic table, one kind of element β selected from elements of the group IIIa in the periodic table and one kind of element γ selected from elements of the groups Ib, IIb, IIIb, IVa and VIIIa in the periodic table or powders of sintered composite oxides obtained by sintering said mixtures and then pulverizing them.

### [Operation]

A method of producing a superconducting material can be mainly characterized by that a series of steps [step of producing a pipe - step of molding - step of drying/removing binders - step of sintering] are continuously carried out. In other words, the process can be simplified and continuously carried out as a whole by the step of turning the plate material into the pipe and the supply of the raw material powders at the same time.

That is to say, as mentioned later, the metallic pipe having a small diameter preferably used as the material of the superconducting wire is produced generally in the form of electric welded tube. This step, as concretely mentioned later, is carried out by at first turning the plate material into the pipe having a U-shaped section by pressing and then the pipe having an O-shaped section followed by subjecting the butt portions to the seam welding. In these steps, the pipe does not form a closed section until after the seam welding. In particular, after the plate material is turned into the pipe having a U-shaped section, its portion corresponding to a side of the pipe is greatly opened. Accordingly, prior to the time when the pipe having a U-shaped section is turned into the pipe having an O-shaped section the former can be continuously supplied with the raw material powders from the side thereof.

Accordingly, the raw material powders are already housed in the pipe at the time when the plate material is formed as the pipe having a small diameter. Consequently, the material formed in a thin wire-like shape can be sintered to produce the superconducting wire by subjecting the pipe with the raw material powders housed therein to the drawing and heating treatment.

As concretely mentioned later, the steps from the step of molding to the step of sintering can be continuously carried out, so that an appointed quantity of raw materials can be produced in the form of continuous product, whereby the long member, such as electric power transmission medium, can be advantageously produced.

In addition, it goes without saying that in these steps all of the conventional techniques accumulated in the production of electric welded tubes can be applied, that is, the plate material is turned into a pipe having a C-shaped section (by the use of a crimping press) before it is turned into the pipe having a U-shaped section or the butt surfaces formed when the pipe having a U-shaped section is formed are ground to expose the activated surface.

In addition, as mentioned later, some materials, of which the pipe is formed, bring about chemical reactions with composite oxide superconducting materials. In this case, it is preferable that the surface of the plate material is subjected to the surface treatment, for example the surface of the plate material is previously coated with stable substances.

The superconducting wire produced according to the present invention is a sintered wire with a sheath member having superior superconducting characteristics incidental to composite oxide sintered bodies. And, the sheath member functions as a support member, so that the superconducting wire produced according to the present invention has also a high mechanical strength. In addition, if the sheath member is formed of conductors, the sheath member functions as a current by-path and a radiating passage when quenched.

In view of these working methods and the desired characteristics, a plate material formed of one kind selected from the group consisting of stainless steel, Cu, Ag, Au, Pt, Pd, Rh, Fe, Pb, Sn, Cd, Ti, W, Mo, Zr, Hf, Ta and Nb or alloys thereof as the plate material, of which the pipe is formed, but it is not limited to them. In addition, Cu, Fe and the like are advantageous in easy workability and inexpensiveness, stainless steel and Pt being advantageous in chemical stability to have no chemical influence upon the superconducting material, and further Ag, Pd, Rh and the like being advantageous as the sheath member of the superconducting material, for which in particular the control of oxygen-concentration is required, since some of their oxides emit oxygen due to the change of temperature. The material of these sheath members should be suitably selected depending upon the use of the superconducting material and the like.

In addition, the method according to the present invention can be widely used as a method of producing long sintered products but in particular the use of composite oxide sintered bodies expressed by the general formula α_{w} βₓ γ_{y} δ_{z}, wherein an element α is one kind selected from elements of the group IIa in the periodic table; an element β being one kind selected from elements of the group IIIa in the periodic table; an element γ being one kind selected from elements of the groups Ib, IIb, IIIb and VIIIa in the periodic table; δ being O; w, x, y and z being a number meeting 1 ≦ w ≦ 5, 1 ≦ x ≦ 5, 1 ≦ y ≦ 15 and 1 ≦ z ≦ 20, respectively, as the superconducting material leads to a more advantageous effect. In addition, said composite oxides include in particular composite oxides, such as Ba - Y - Cu, Ba - Ho - Cu, Sr - La - Cu or Ba - Dy - Cu, exhibiting particularly superior characteristics. These composite oxides seem to have a so-called pseudo-perovuskite type crystalline structure including oxygen vacancies such as an orthorhombic structure. Such superconducting materials can be effectively used as the transmission medium of electric power and the like by turning them into a long superconductor according to the present invention.

It is desired in the sintering step of these composite oxide powders that the sintering temperature has an upper limit at a melting point of the sintered body and a difference between the sintering temperature and the melting point of the sintered body is 100°C or less, Because if the sintering temperature is lower than the above described range, the sintering reaction of the sintered body powders is not made progress and the strength of the resulting sintered body is extraordinarily reduced while if the sintering temperature exceeds the above described range, the liquid phase is produced during the sintering step to lead to the melting or decomposition of the sintered body, whereby remarkably lowering Tc of the sintered body.

In addition, according to the discovery by the present inventors, the addition of powdery oxides, carbonates, sulfates or nitrates of at least one kind of element selected from the group consisting of V, Nb, Ta, Mo, W, Ti, Cr, Mn, Ga, In, Cd, Sn, Tl, Pb and Zn to the element γ at an atomic ratio of about 0.01 to 0.15 leads to more superior superconducting characteristics. In addition, it is preferable that the raw material powders have a particle diameter of 10 microns or less. The pulverization of the raw material powders realizes the effective sintering reaction, the uniform structure and an increase of an intercrystalline surface area playing an important function for the superconducting characteristics.

The present invention is below concretely described with reference to the preferred embodiments but the following preferred embodiments are merely illustrative. The technical scope of the present invention is not limited by them.

The drawings are below briefly described.

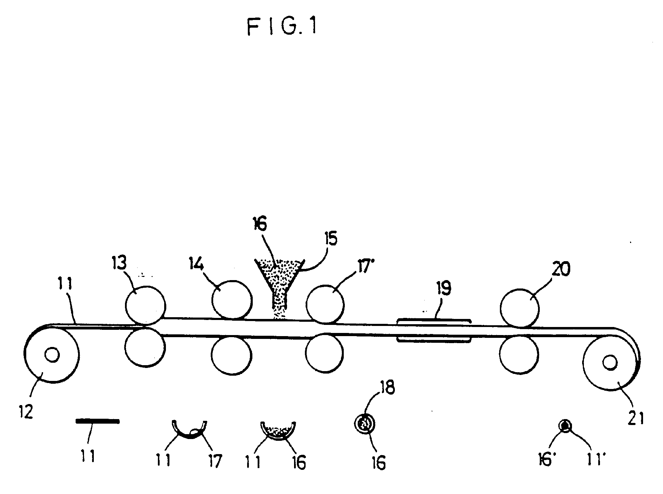

Fig. 1 is a progress chart showing the method of producing the superconducting wire according to EXAMPLE 1 of the present invention.

### EXAMPLE 1

As shown in Fig. 1, a band copper wire 11 is continuously drawn from a reel 12 and passed over forming rolls 13, 14 to bend said copper wire 11 in a flume-like shape.

After passing over the forming rolls 13, 14, the bent concave portion 17 of the copper wire 11 is supplied with powdery oxide superconducting materials 16 from a feeder 15.

Subsequently, the copper wire is further bent in a forming roll 17′ to approach both end edges thereof to each other and envelop said materials 16 with leaving a slight gap 18. This gap 18, which does not drop the materials 16 and can sufficiemtly supply the materials 16 housed in the copper wire with oxygen in the subsequent sintering step, is sufficient.

Said materials 16 are sintered in a sintering firnace 19 with supplying them with oxygen. After sintering, the copper wire 11 is passed over a rolling roll 20 to draw a clad copper wire 11′ and sintered bodies 16′ housed in said clad copper wire 11′ integrally until the desired diameter followed by rolling up on a reel 21.

In addition, in order to completely turn the sintered bodies 16′ housed in said clad copper wire 11′ into a solid solution, the clad copper wire 11′ housing the sintered bodies 16′ may be subjected to an additional heat treatment before it is rolled up on the reel 21.

In addition, although powdery oxide superconducting materials are used in the above described EXAMPLE, molten oxide superconducting materials may be supplied in the bent concave portion with chilling to coagulate.

In addition, aluminium, silver or alloys thereof can be used as the conductor in addition to the above described copper. Besides, every oxide superconducting material comprising any one of Ca, Ba and Sr, any one of Y, Sc and lanthanoides, any one of Cu, Ag and Au and any one of O, F, N and C can be used.

### EXAMPLE 2

A stainless steel plate having a width of 25 mm, a length of 1,000 mm and a thickness of 1 mm was bent to form a flume having a U-shaped section and an opened portion of 5 mm wide.

On the other hand, a mixture comprising powders of Bi₂O₃, SrCO₃, CaCO₃ and CuO having an average particle diameter of 5 microns or less, so that the composition may become Bi₄Sr₃Ca₃Cu₄Oₓ after the baking process, was preliminarily baked in air at 800°C for 5 hours and then cooled followed by melting at 1,100°C in a platinum crucible.

The resulting flume having a U-shaped section was closed at both ends thereof and then heated at 800°C followed by supplying an inside thereof with said molten mixture.

Subsequently, the flume was subjected to a heat treatment in air at 840°C for 5 hours.

The critical temperature Tc and the temperature Tci of the resulting heat treated product, at which the electric resistance becomes completely zero, were measured by the direct current four-probe method within a cryostat with fitting electrodes to both ends of the sample with an electrically conductive Ag paste according to the usual method. The temperature was measured by means of a calibrated Au(Fe) - Ag thermocouple. The change in resistance was observed with rising the temperature little by little.

Tc was 121 K and Tci was 80 K. In addition, this superconducting wire did not produce any gap between the flume and the superconductor even after the heat cycle of room temperature-liquid nitrogen was repeated 100 times.

### [Effects of the Invention]

As above described in detail, according to a method of producing a superconducting wire of the present invention, a long composite oxide superconducting material having a high critical temperature can be continuously produced. Thus, the superconducting material can be actually utilized as for example a transmission medium of electric power and the like. In addition, a long superconducting product produced according to the present invention has a metallic sheath member therearound, so that this metallic sheath member functions as a mechanical support member and a by-path of electric current when quenched.

In addition, the present invention consists in that the bent concave portion of the conductor bent in flume-shape is supplied with the oxide superconducting materials and the sintering is carried out under the condition that the materials are enveloped in the conductor so as to form a minute gap between both end edges of the conductor, so that the sintering can be carried out with adjusting the concentration of oxygen.

Accordingly, the present invention exhibits an effect in that the composite wire comprising the conductor and the superconductor can be produced by a single continuous process.

## Claims

1. A method of producing a superconducting wire, characterized in that a band conductor (11) consisting of a metal or of an alloy, being continuously supplied, is bent in a flume-like shape and the resulting bent concave portion (17) is supplied with an oxide superconducting material (16) followed by bending said conductor, so that a slight gap (18) is left between both edges of the bent band conductor, to envelop said material (16) in the conductor, and subsequently, said material is sintered and then subjected to rolling to a clad wire of a desired diameter.

2. A method of producing a superconducting wire as set forth in claim 1, characterized in that said oxide superconducting material (16) is powdery.

3. A method of producing a superconducting wire as set forth in claim 1, characterized in that said oxide superconducting material (16) is molten and supplied in the bent concave portion of the conductor with chilling to coagulate.

## Patentansprüche

1. Verfahren zur Herstellung eines supraleitenden Drahtes, dadurch gekennzeichnet, daß ein Bandleiter (11), der aus einem Metall oder einer Legierung besteht und kontinuierlich zugeführt wird, in eine rinnenähnliche Form gebogen wird und der enstandene gebogene konkave Teil (17) mit einem Oxid-supraleitenden Material (16) zugeführt wird, gefolgt von Biegen des Leiters, so daß ein leichter Spalt (18) zwischen beiden Kanten des gebogenen Bandleiters gelassen wird, um das Material (16) in dem Leiter einzuschließen, und anschließend das Material gesintert wird und dann zu einem plattierten Draht eines gewünschten Durchmessers gewalzt wird.

2. Verfahren zur Herstellung eines supraleitenden Drahtes nach Anspruch 1, dadurch gekennzeichnet, daß das Oxidsupraleitende Material (16) pulverig ist.

3. Verfahren zur Herstellung eines supraleitenden Drahts nach Anspruch 1, dadurch gekennzeichnet, daß das Oxidsupraleitende Material (16) geschmolzen und in den gebogenen konkaven Teil des Leiters unter Kühlen zum Koagulieren eingeführt wird.

## Revendications

1. Procédé de production d'un fil supraconductcur, caractérisé en ce qu'une bande conductrice (11) constituée d'un métal ou d'un alliage, fabriquée en continu, est pliée en forme de rigole et la partie concave pliée ainsi obtenue (17) est alimentée en matériau supraconducteur à base d'oxyde (16) à la suite de quoi ledit conducteur est plié, de sorte qu'un léger écart résiduel (18) est généré entre les deux bords de la bande conductrice pliée, en vue d'envelopper ledit matériau (16) avec le conducteur, ledit matériau étant ultérieurement fritté puis soumis à un laminage pour ajuster le diamètre du fil de revêtement.

2. Procédé de production d'un fil supraconducteur tel que défini dans la revendication 1, caractérisé en ce que ledit matériau supraconducteur à base d'oxyde (16) est sous forme pulvérulente.

3. Procédé de production d'un fil supraconducteur tel que défini dans la revendication 1, caractérisé en ce que ledit matériau supraconducteur à base d'oxyde (16) est fondu et introduit dans la partie concave pliée du conducteur sous refroidissement pour induire une coagulation.
